# EUROPÄISCHE PATENTSCHRIFT

(11) **EP 1 264 521 B1**
(45) Veröffentlichungstag und Bekanntmachung des Hinweises auf die Patenterteilung: **23.05.2007**
(21) Anmeldenummer: 01927583.3
(22) Anmeldetag: 15.03.2001
(51) Int. Cl.: H05K 5/00, G02B 6/42

(54) **VERBINDUNGSSYSTEM**
CONNECTION SYSTEM
SYSTEME D'ASSEMBLAGE

(30) Priorität: 15.03.2000 DE 10013843
(43) Veröffentlichungstag der Anmeldung: 11.12.2002
(73) Patentinhaber: Finisar Corporation, Sunnyvale, CA 94089 (US)
(72) Erfinder: STOCKHAUS, Andreas, 14199 Berlin (DE)
(74) Vertreter: Müller, Wolfram Hubertus
(86) Internationale Anmeldenummer: PCT/DE2001/001091
(87) Internationale Veröffentlichungsnummer: WO 2001/069992

(56) Entgegenhaltungen:
- DE-C- 19 742 496
- DE-U- 29 913 281
- US-A- 5 734 558

## Beschreibung

Die Erfindung liegt auf dem Gebiet der Montage elektronischer Bauteile oder Module, insbesondere elektrooptischer Module (sog. Transceiver). Bei der Montage derartiger Module auf Trägern, z.B. mit Leiterbahnen und Anschlußkontakten versehenen Leiterplatten, besteht anwenderseitig die Forderung nach verhältnismäßig frei und uneingeschränkt auf der Leiterplatte plazierbaren Modulen. Dabei werden Modulbauformen und geeignete mechanische Verbindungen gefordert, die - je nach verfügbarem Montageraum und Zugänglichkeit - ein einfaches horizontales Einbringen der Module in geeignete Halterungen erlauben oder eine vertikale Montage der Module zulassen.

Aus der US-PS 5,734,558 gehen Modulvarianten mit jeweils einer Anschlußkontaktleiste hervor, die entweder an der Modulunterseite rechtwinklig hervorsteht oder eine die schmale Rückwand des in Einschubrichtung gesehen hinteren Modulbereichs durchdringt. Die erste Modulvariante erlaubt damit nur eine zu einer Halterung ausschließlich senkrechte Montage, bei der federnde elektrische Kontakte der modulseitigen Kontaktleiste vertikal in entsprechende kooperierende Kontakte einer halterungsseitigen Kontaktaufnahme eindringen. Diese Variante erfordert zur Montage bzw. Demontage einen entsprechenden Freiraum in vertikaler Richtung über der Halterung. Die andere Variante erlaubt nur eine Montage in einer zur Halterungsoberseite parallelen horizontalen Richtung, die einen entsprechenden Freiraum vor der Halterung erfordert. Im übrigen ist bei beiden Varianten eine präzise Führung des Moduls während der Verbindung mit der Halterung nicht vorgesehen.

Aus der DE-U-299 13 281 ist ein gattungsgemäßes Verbindungssystem zur lösbaren mechanischen Verbindung eines elektronischen Bauteils mit einer Halterung bekannt. Das bekannte Verbindungssystem betrifft eine Rastverbindung von Gegenständen mit einem in eine Rastaufnahme einrastenden Rastglied, das mittels einer Schwenkbewegung in die Rastposition überführt wird und bei der Schwenkbewegung an einem Anschlag der Rastaufnahme anliegt.

Aufgabe der Erfindung ist es, ein anwenderfreundliches Verbindungssystem zur lösbaren mechanischen Verbindung eines elektronischen Bauteils mit einer Halterung zur schaffen, das auch bei einem geringen zur Verfügung stehenden Freiraum eine einfache Montage, mit geringem Zeitaufwand ermöglicht.

Diese Aufgabe wird dadurch gelöst, daß die Halterung mindestens ein Anschlagelement aufweist, das für das relativ zu der Halterung bewegte elektronische Bauteil eine Anschlagposition bereitstellt, wobei das elektronische Bauteil in der Anschlagposition mittels einer Schwenkbewegung zwischen einer geöffneten Stellung, in welcher das elektronische Bauteil von der Halterung trennbar ist und einer Endstellung, in welcher die lösbare mechanische Verbindung geschlossen ist, bewegbar ist. Weiter sind Vorspannmittel vorgesehen, die so ausgebildet sind, dass das elektronische Bauteil wenigstens auf einem Teil eines bei der Schwenkbewegung von der geöffneten Stellung in die Endstellung zurückgelegten Weges entgegen der Richtung der Schwenkbewegung mechanisch vorgespannt ist. Hierdurch bewegt sich das elektronische Bauteil beim Lösen der mechanischen Verbindung anfänglich automatisch in einer Richtung auf die geöffnete Stellung zu und kann dann zum vollständigen Lösen der mechanischen Verbindung von der Halterung getrennt werden.

Die Vorspannmittel umfassen vom Boden der Halterung abstehende, federnde Vorsprünge, die auf dem wenigstens einen Teil des bei der Schwenkbewegung zurückgelegten Weges auf das elektronische Bauteil eine Federkraft ausüben und/oder sind als Teil einer elektrischen Massekontaktverbindung des elektronischen Bauteils ausgebildet. In letzerem Fall kann die Anzahl der Teile des Verbindungssystems möglichst gering gehalten werden. Die Vorspannmittel erfüllen in diesem Fall sowohl eine mechanische als auch eine elektrische Funktion.

Das elektronische Bauteil kann bei der Montage zur Ausbildung der lösbaren mechanischen Verbindung zunächst unter optimaler Ausnutzung des vorhandenen Montagefreiraums an die Halterung herangeführt werden, um das elektronische Bauteil in die Anschlagposition zu bringen, in welcher die Position des elektronischen Bauteils relativ zur Halterung zumindest teilweise mit Hilfe des Anschlagelementes festgelegt ist. Anschließend wird das elektronische Bauteil mittels einer Schwenkbewegung von der geöffneten Stellung in die Endstellung gebracht, wobei die Anschlagelemente gewährleisten, daß sich das elektronische Bauteil und die Halterung während der Schwenkbewegung so aufeinander zu bewegen, daß das elektronische Bauteil in die gewünschte Endstellung gelangt. Die Anschlagelemente ermöglichen somit eine Montagesequenz der lösbaren mechanischen Verbindungen, bei der einerseits ein geringer Platzbedarf für die Montage besteht. Andererseits gewährleisten die Anschlagelemente, daß das elektronische Bauteil und die Halterung während des Übergangs in die Endstellung in der Anschlagposition so zueinander positioniert sind, daß die mechanische Verbindung in der für die Funktion des Verbindungssystems notwendige Art und Weise ausgebildet wird. Der Einsatz von Vorspannmitteln ist anwenderfreundlich.

Eine zweckmäßige Weiterbildung der Erfindung sieht vor, daß das Anschlagelement aus einem von einem Boden der Halterung abstehenden Vorsprung besteht, wodurch mit geringem Herstellungsaufwand mechanisch zuverlässige Anschlagelemente gebildet sind.

Bei einer Fortbildung der Erfindung ist der wenigstens eine abstehende Vorsprung von einem abgewinkelten Abschnitt des Bodens gebildet, wodurch der Vorsprung mittels eines geringen fertigungstechnischen Aufwands geschaffen ist, ohne das ein Verfahrensschritt zur Befestigung des wenigstens einen Vorsprungs am Boden notwendig ist.

Eine vorteilhafte Ausgestaltung der Erfindung sieht vor, daß das elektronische Bauteil zumindest einen von einer Seitenwand des elektronischen Bauteils abstehenden Vorsprung aufweist, welcher mit den Anschlagelementen mechanisch zusammenwirkt. Hierdurch ist auf einfache Weise ein Zusammenwirken des elektronischen Bauteils mit den Anschlagelementen gewährleistet.

Vorteilhaft kann vorgesehen sein, daß das elektronische Bauteil in der Endstellung mit Hilfe von Verriegelungsmitteln mit der Halterung verriegelt ist, wodurch ein Verbindungssystem geschaffen ist, das gegen das unbeabsichtigte Lösen der mechanischen Verbindung gesichert ist.

Eine zweckmäßige Ausgestaltung der Erfindung sieht vor, daß die Verriegelungsmittel einen an dem elektronischen Bauteil federnd gelagerten Vorsprung umfassen, welcher in der Endstellung des elektronischen Bauteils in einer Aussparung der Halterung angeordnet ist. Hierdurch ist eine mechanisch einfache Lösung zur Verriegelung des elektronischen Bauteils geschaffen, bei der das Verriegeln und das Lösen der Verriegelung zwischen dem elektrischen Bauteil und der Halterung mit geringem Aufwand ermöglicht sind.

Eine hinsichtlich der Montagesicherheit zweckmäßige Weiterbildung der Erfindung sieht vor, daß in der geöffneten Stellung, im Verlauf der Schwenkbewegung und in der Endstellung eine Seitenfläche des elektronischen Bauteils und eine Seitenfläche der Halterung zumindest teilweise aneinanderliegend angeordnet sind. Hierdurch ist bezüglich der Position des elektronischen Bauteils relativ zur Halterung eine Montagehilfe in Form einer Führungsunterstützung geschaffen.

Eine bevorzugte Fortbildung der Erfindung sieht vor, daß die Halterung einer mit Hilfe der SMD-Technik ("surface mounted device"-Technik) auf einer Platine montierbare Halterung ist, die auf einer unteren Oberfläche des Bodens Lotflächen aufweist, wodurch das Verbindungssystem kostengünstig angewendet werden kann.

Eine hinsichtlich der mit Hilfe des Verbindungssystems auszubildenden elektrischen Verbindung bevorzugte Weiterbildung der Erfindung sieht vor, daß die Halterung ein Anschlußbauteil mit Anschlußkontakten umfaßt, die in der Endstellung eine Federkraft auf Anschlußflächen des elektrischen Bauteils ausüben. Die auf die Anschlußflächen wirkende Federkraft unterstützt weiterhin das Lösen des elektrischen Bauteils aus der Endstellung.

Die Erfindung wird im Folgenden anhand eines Ausführungsbeispiels unter Bezugnahme auf eine Zeichnung näher erläutert. Hierbei zeigen:
- Figuren 1a, 1b: eine perspektivische Darstellung einer Halterung von oben bzw. von unten;
- Figur 2: die Halterung nach den Figuren 1a und 1b mit einem Anschlußteil;
- Figuren 3a, 3b: eine perspektivische Darstellung eines elektronischen Bauteils von oben bzw. von unten;
- Figur 4: eine perspektivische Darstellung, wobei das elektronische Bauteil oberhalb der Halterung mit dem Anschlußteil gezeigt ist;
- Figuren 5a, 5b: eine perspektivische Darstellung eines von dem elektronischen Bauteil und der Halterung gebildeten Verbindungssystems, wobei das elektronische Bauteil auf der Halterung teilweise bzw. vollständig montiert ist; und
- Figur 6: eine weitere perspektivische Darstellung des montierten Verbindungssystems.

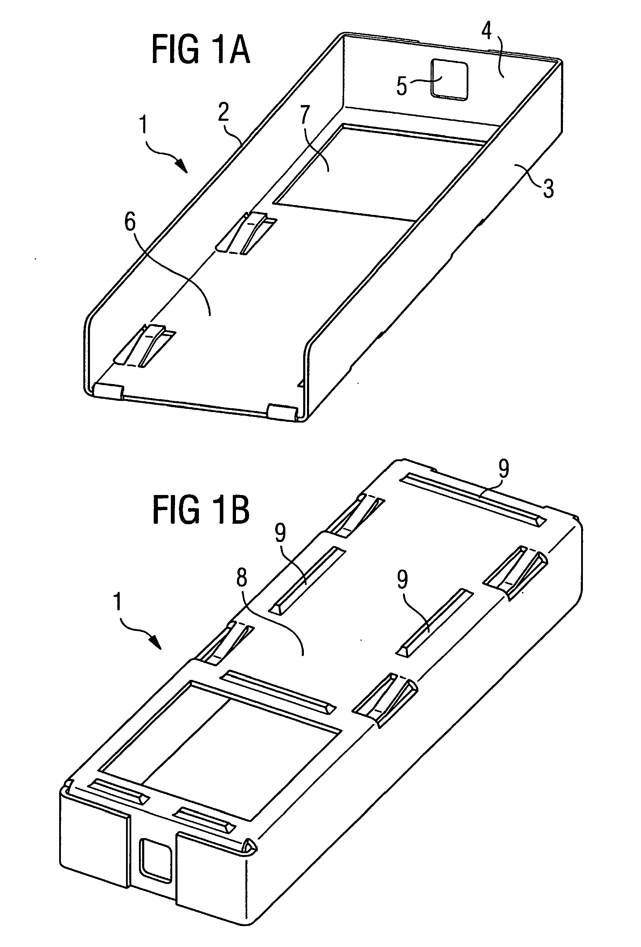

Figur 1a zeigt eine perspektivische Darstellung einer Halterung 1. Die Halterung 1 weist längsseitig Seitenwände 2, 3 auf. In einer stirnseitigen Wand 4 ist eine Öffnung 5 ausgebildet. Im Boden 6 der Halterung 1 ist eine weitere Öffnung 7 vorgesehen, die, wie später im Detail erklärt wird, zur Aufnahme eines Anschlußteils dient.

In Figur 1b ist die Halterung 1 aus Figur 1a perspektivisch von unten dargestellt. Die Halterung 1 weist auf einer Unterseite 8 des Bodens 6 Lotflächen 9 auf. Mit Hilfe der Lotflächen 9 kann die Halterung auf eine Oberfläche einer Leiterplatte bzw. Platine aufgelötet werden. Hierbei wird vorzugsweise die SMD-Technik ("surface mounted device"-Technik) genutzt.

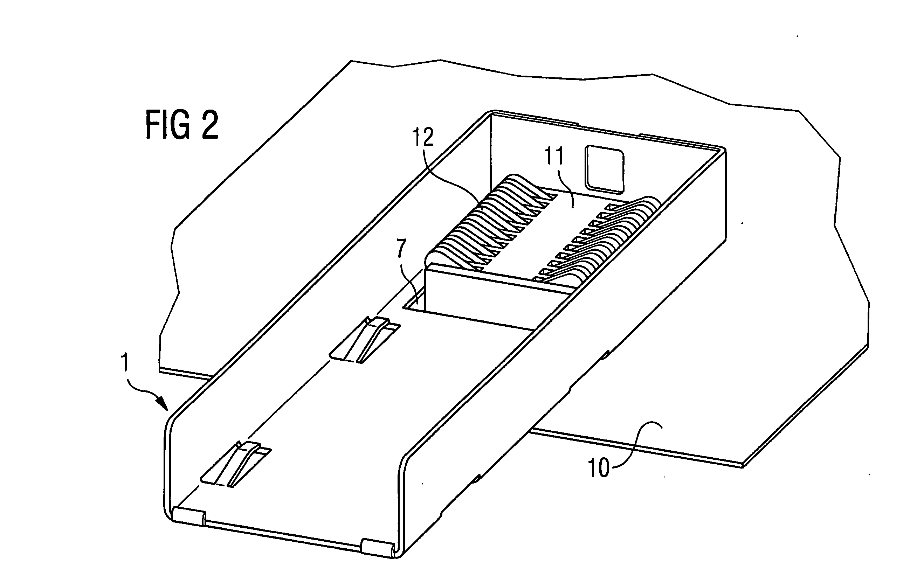

Figur 2 zeigt eine auf einer lediglich angedeuteten Platine 10 montierte Halterung 1. Hierbei ist die Halterung 1 auf der Platine 10 so montiert, daß ein Anschlußteil 11 in der weiteren Öffnung 7 der Halterung 1 angeordnet ist. Das Anschlußteil 11 weist Anschlußkontakte 12 auf, die vorzugsweise als Federkontakte ausgebildet sind und über Leiterbahnen auf der Platine 10 mit elektrischen/elektronischen Bauelementen (nicht dargestellt) verbunden sind, die auf der Platine 10 angeordnet sein können oder mit den Leiterbahnen (nicht dargestellt) der Platine 10 elektrisch verbunden sind.

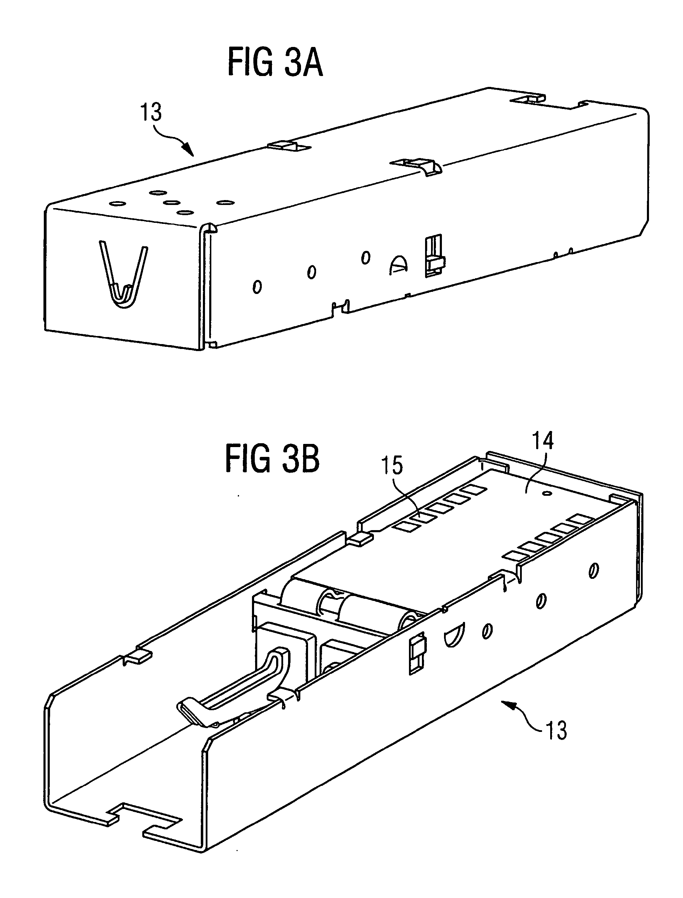

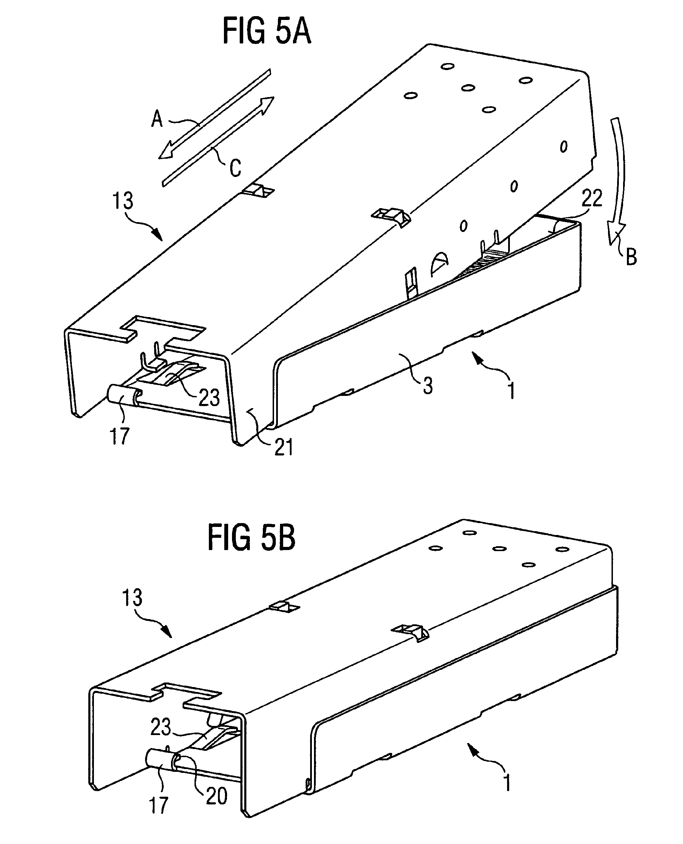

Zur Ausbildung eines elektronischen Moduls, insbesondere eines elektrooptischen Moduls wird auf der Halterung 1 ein in Fiugr 3a dargestelltes elektronisches Bauteil 13 montiert. Gemäß Figur 3b weist das elektronische Bauteil 13 eine kleine Leiterplatte 14 mit Anschlußflächen 15 auf. Wenn das elektronische Bauteil 13 auf der Halterung 1 montiert ist (vgl. Figur 5b) üben die als Federkontakte ausgebildeten Anschlußkontakte 12 eine Federkraft auf die Anschlußflächen 15 aus.

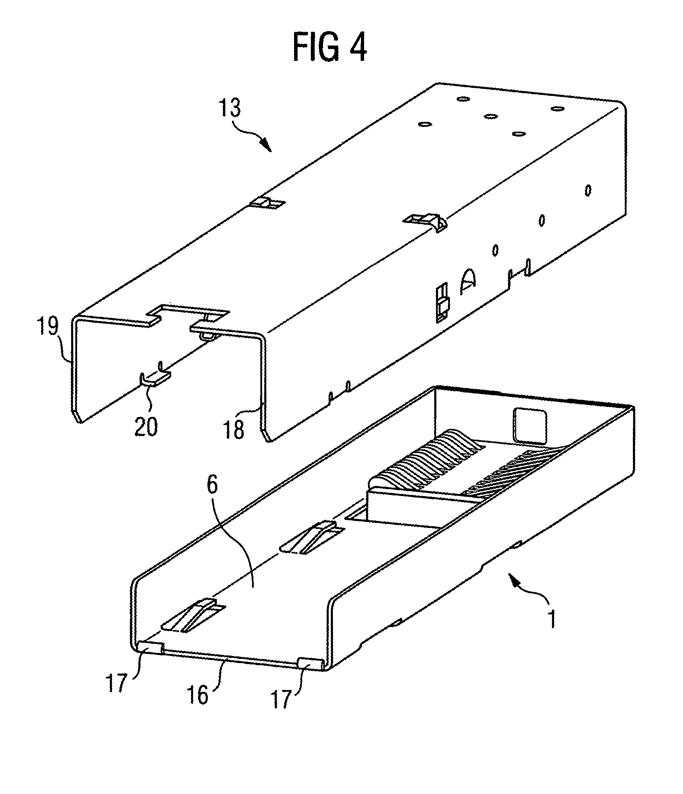

Figur 4 zeigt eine perspektivische Darstellung, in welcher das elektronische Bauteil 13 aus den Figuren 3a und 3b oberhalb der Halterung 1 aus den Figuren 1a, 1b und 2 dargestellt ist. An einer Vorderseite 16 der Halterung 1 sind Vorsprünge 17 ausgebildet, die von dem Boden 6 nach oben abstehen. Gemäß Figur 4 weist das elektronische Bauteil 13 im unteren Bereich von Seitenwänden 18, 19 weitere Vorsprünge 20 auf. Die Vorsprünge 17 an der Stirnseite 16 der Halterung 1 dienen bei der Montage des elektronischen Bauteils 13 auf der Halterung 1 als Anschlagelemente für die Vorsprünge 20 des elektronischen Bauteils 13. Bei der Montage wird das elektronische Bauteil gemäß Figur 5a im wesentlichen einer mit Hilfe eines Pfeils A angedeuteten Richtung auf die Halterung 1 zu bewegt, bis die weiteren Vorsprünge 20 des elektronischen Bauteils 13 an die Vorsprünge 17 der Halterung 1 stoßen, so daß das elektronische Bauteil 13 in einer Anschlagposition ist. Das elektronische Bauteil 13 ist dann bezüglich der Halterung 1 in einer geöffneten Stellung angeordnet, in welcher ein Verrutschen des elektronischen Bauteils in Richtung des Pfeiles A mit Hilfe der Vorsprünge 17 und der weiteren Vorsprünge 20 verhindert ist. Anschließend wird das elektronische Bauteil 13 mittels einer Schwenkbewegung (vgl. Pfeil B in Figur 5a) in eine Endstellung bewegt, die in Figur 5b dargestellt ist.

Sowohl in der geöffneten Stellung gemäß Figur 5a als auch in der Endstellung gemäß Figur 5b ist eine Seitenfläche 21 des elektronischen Bauteils 13 wenigstens teilweise an einer Innenfläche 22 der Seitenwand 3 der Halterung 1 angeordnet. Hierdurch wird das elektronische Bauteil beim Übergang von der geöffneten Stellung (vgl. Figur 5a) in die Endstellung (vgl. Figur 5b) geführt.

Beim Übergang von der geöffneten Stellung (vgl. Figur 5a) in die Endstellung (vgl. Figur 5b) muß eine Federkraft überwunden werden, die von federnden Vorsprüngen 23 (vgl. Figur 4, 5a bzw. 5b) auf das elektronische Bauteil 13 ausgeübt wird.

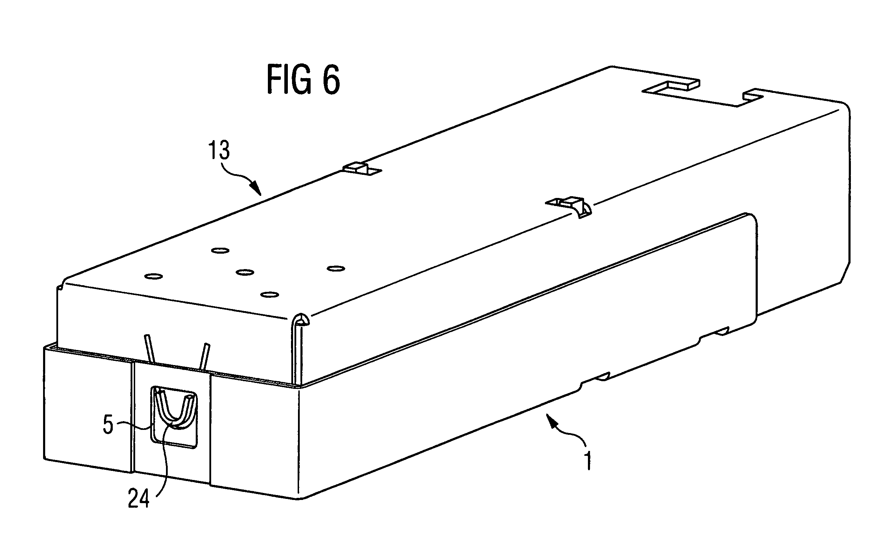

Gemäß Figur 6 weist das elektronische Bauteil 13 einen stirnseitig angeordneten, federnden Vorsprung 24 auf, der in der in Figur 6 dargestellten Endstellung in die stirnseitige Öffnung 5 der Halterung 1 eingreift. Die von den federnden Vorsprüngen 23 am Boden 6 der Halterung 1 ausgeübte Federkraft dient beim Lösen der mit Hilfe des federnden Vorsprungs 24 ausgebildeten Verriegelung zwischen dem elektronischen Bauteil 13 und der Halterung 1 dazu, das elektronische Bauteil 13 nach oben (entgegen Pfeil B in Figur 5a) zu drücken, so daß das elektronische Bauteil 13 von der Halterung 1 in einer Richtung getrennt werden kann, die in Figur 5a mittels eines Pfeils C angedeutet ist.

## Patentansprüche

1. Verbindungssystem zur lösbaren mechanischen Verbindung eines elektronischen Bauteils (13) mit einer Halterung (1), wobei die Halterung (1) mindestens ein Anschlagelement aufweist, das für das relativ zu der Halterung (1) bewegte elektronische Bauteil (13) eine Anschlagposition bereitstellt, wobei das elektronische Bauteil (13) in der Anschlagposition mittels einer Schwenkbewegung zwischen einer geöffneten Stellung, in welcher das elektronische Bauteil (13) von der Halterung (1) trennbar ist und einer Endstellung, in welcher die lösbare mechanische Verbindung geschlossen ist, bewegbar ist, und wobei Vorspannmittel vorgesehen sind, die so ausgebildet sind, dass das elektronische Bauteil (13) wenigstens auf einem Teil eines bei der Schwenkbewegung von der geöffneten Stellung in die Endstellung zurückgelegten Weges entgegen der Richtung der Schwenkbewegung (B) mechanisch vorgespannt ist, **dadurch gekennzeichnet, dass** die Vorspannmittel vom Boden (6) der Halterung (1) abstehende, federnde Vorsprünge (23) umfassen, die auf dem wenigstens einen Teil des bei der Schwenkbewegung zurückgelegten Weges auf das elektronische Bauteil (13) eine Federkraft ausüben und/oder dass die Vorspannmittel als Teil einer elektrischen Massekontaktverbindung des elektronischen Bauteils (13) ausgebildet sind.

2. Verbindungssystem nach Anspruch 1, **dadurch gekennzeichnet, dass** das Anschlagelement aus einem von einem Boden (6) der Halterung (1) abstehenden Vorsprung (17) besteht.

3. Verbindungssystem nach Anspruch 2, **dadurch gekennzeichnet, dass** der wenigstens eine abstehende Vorsprung (17) von einem abgewinkelten Abschnitt des Bodens (6) gebildet ist.

4. Verbindungssystem nach einem der vorangehenden Ansprüche, **dadurch gekennzeichnet, dass** das elektronische Bauteil (13) zumindest einen von einer Seitenwand (18) des elektronischen Bauteils (13) abstehenden Vorsprung (20) aufweist, welcher mit den Anschlagelementen der Halterung (1) mechanisch zusammenwirkt.

5. Verbindungssystem nach einem der vorangehenden Ansprüche, **dadurch gekennzeichnet, dass** das elektronische Bauteil (13) in der Endstellung mit Hilfe von Verriegelungsmitteln mit der Halterung (1) verriegelt ist.

6. Verbindungssystem nach Anspruch 5, **dadurch gekennzeichnet, dass** die Verriegelungsmittel einen an dem elektronischen Bauteil (13) federnd gelagerten Vorsprung (24) umfassen, welcher in der Endstellung in einer Aussparung (5) der Halterung (1) angeordnet ist.

7. Verbindungssystem nach einem der vorangehenden Ansprüche, **dadurch gekennzeichnet, dass** in der geöffneten Stellung, im Verlauf der Schwenkbewegung und in der Endstellung eine Seitenfläche (2) des elektronischen Bauteils (13) und eine Seitenfläche (22) der Halterung (1) zumindest teilweise aneinanderliegend angeordnet sind.

8. Verbindungssystem nach einem der vorangehenden Ansprüche, **dadurch gekennzeichnet, dass** die Halterung (1) eine mit Hilfe der SMD-Technik ('surface mounted device'-Technik) montierbare Halterung ist, die auf einer unteren Oberfläche (8) des Bodens (6) Lotflächen (9) aufweist.

9. Verbindungssystem nach einem der vorangehenden Ansprüche, **dadurch gekennzeichnet, dass** die Halterung (1) ein Anschlußbauteil (11) mit Anschlußkontakten (12) umfaßt, die in der Endstellung eine Federkraft auf Anschlußflächen (15) des elektronischen Bauteils (13) ausüben.

10. Verbindungssystem nach einem der vorangehenden Ansprüche, **dadurch gekennzeichnet, dass** das Anschlagelement (17) in der Anschlagposition in Kontakt mit einem Vorsprung (20) des elektronischen Bauteils (13) steht, der von einer Seitenwand (18, 19) des elektronischen Bauteils (13) in einer Richtung senkrecht zu der Relativbewegung (A) des elektronischen Bauteils (13) absteht.

11. Verbindungssystem nach den Ansprüchen 2 und 10, **dadurch gekennzeichnet, dass** ein Vorsprung (17) der Halterung (1) jeweils als Anschlagelement für einen zugeordneten Vorsprung (20) des elektronischen Bauteils (13) dient.

12. Verbindungssystem nach einem der Ansprüche 2 bis 11, **dadurch gekennzeichnet, dass** das als Vorsprung (17) ausgebildete Anschlagelement an der Stirnseite (16) der Halterung (1) angeordnet ist.

13. Verbindungssystem nach einem der vorangehenden Ansprüche, **dadurch gekennzeichnet, dass** sowohl die Halterung (1) als auch das elektronische Bauteil (13) jeweils zwei parallel verlaufende Seitenwände (2, 3; 18, 19) aufweisen, wobei jeweils eine Seitenwand (2, 3) der Halterung (1) und eine Seitenwand (18, 19) des elektronischen Bauteils (13) in der geöffneten Stellung, im Verlauf der Schwenkbewegung und in der Endstellung zumindest teilweise aneinanderliegend angeordnet sind.

## Claims

1. Connection system for the detachable mechanical connection of an electronic component (13) to a holder (1), the holder (1) having at least one stop element providing a stop position for the electronic component (13) moved relative to the holder (1), the electronic component (13) being movable in the stop position by a pivoting movement between an open position, in which the electronic component (13) can be separated from the holder (1), and an end position, in which the detachable mechanical connection is closed, and provision being made for prestressing means formed such that the electronic component (13) is prestressed mechanically counter to the direction of the pivoting movement (B), at least over part of a distance covered during the pivoting movement from the open position into the end position, **characterised in that** the prestressing means contain resilient protrusions (23) which project from the base (6) of the holder (1) and exert a spring force on the electronic component (13) over at least part of the distance covered during the pivoting movement and/or **in that** the prestressing means form part of an electrical earth contact connection of the electronic component (13).

2. Connection system according to claim 1, **characterised in that** the stop element consists of a protrusion (17) projecting from a base (6) of the holder (1).

3. Connection system according to claim 2, **characterised in that** the at least one projecting protrusion (17) is formed by an angled portion of the base (6).

4. Connection system according to any one of the preceding claims, **characterised in that** the electronic component (13) has at least one protrusion (20) which projects from a side wall (18) of the electronic component (13) and interacts mechanically with the stop elements of the holder (1).

5. Connection system according to any one of the preceding claims, **characterised in that** the electronic component (13) is locked to the holder (1) in the end position using locking means.

6. Connection system according to claim 5, **characterised in that** the locking means comprise a protrusion (24) which is resiliently mounted on the electronic component (13) and is disposed in the end position in a recess (5) in the holder (1).

7. Connection system according to any one of the preceding claims, **characterised in that** in the open position, in a course of the pivoting movement, and in the end position, a side face (2) of the electronic component (13) and a side face (22) of the holder (1) are disposed to rest on each other, at least to some extent.

8. Connection system according to any one of the preceding claims, **characterised in that** the holder (1) is a holder which can be mounted using the SMD (surface mounted device) method and has soldering areas (9) disposed on a lower surface (8) of the base (6).

9. Connection system according to any one of the preceding claims, **characterised in that** the holder (1) has a connecting component (11) with connecting contacts (12) which, in the end position, exert a spring force onto connecting areas (15) of the electronic component (13).

10. Connection system according to any one of the preceding claims, **characterised in that** the stop element (17) is in contact with a protrusion (20) of the electronic component (13) in the stop position, the protrusion projecting from a side wall (18, 19) of the electronic component (13) in a direction perpendicular to the relative movement (A) of the electronic component (13).

11. Connection system according to claims 2 and 10, **characterised in that** a protrusion (17) of the holder (1) serves in each case as a stop element for an associated protrusion (20) of the electronic component (13).

12. Connection system according to any one of claims 2 to 11, **characterised in that** the stop element in the form of a protrusion (17) is disposed at the front side (16) of the holder (1).

13. Connection system according to any one of the preceding claims, **characterised in that** both the holder (1) and the electronic component (13) have two respective parallel side walls (2, 3; 18, 19), a side wall (2, 3) of the holder (1) and a side wall (18, 19) of the electronic component (13) being, in each case, disposed at least partially adjacent to each other in the open position, during a course of the pivoting movement and in the end position.

## Revendications

1. Système d'assemblage pour l'assemblage mécanique amovible d'un élément constitutif électronique (13) avec un support (1), le support (1) comportant au moins un élément de butée mettant à disposition une position de butée pour l'élément constitutif électronique (13) déplacé par rapport au support (1), l'élément constitutif électronique (13) pouvant être déplacé dans la position de butée au moyen d'un mouvement pivotant entre une position ouverte, dans laquelle l'élément constitutif électronique (13) peut être séparé du support (1), et une position finale, dans laquelle l'assemblage mécanique amovible est fermé, et des moyens de précontrainte étant prévus, qui sont conçus de manière à ce que l'élément constitutif électronique (13) soit mécaniquement précontraint au moins sur une partie d'une course parcourue lors du mouvement pivotant, de la position ouverte à la position finale, à l'encontre du sens du mouvement pivotant (B), **caractérisé en ce que** les moyens de précontrainte comprennent des parties saillantes (23) à effet de ressort, en saillie à partir du fond (6) du support (1), qui exercent une force de ressort sur l'élément constitutif électronique (13), sur la au moins une partie de la course parcourue lors du mouvement pivotant, et/ou **en ce que** les moyens de précontrainte sont conçus comme une partie d'un assemblage électrique de contact de mise à la masse de l'élément constitutif électronique (13).

2. Système d'assemblage selon la revendication 1, **caractérisé en ce que** l'élément de butée se compose d'une partie saillante (17) en saillie à partie d'un fond (6) du support (1).

3. Système d'assemblage selon la revendication 2, **caractérisé en ce que** la au moins une partie saillante (17) est formée par une partie du fond (6) coudée.

4. Système d'assemblage selon l'une des revendications précédentes, **caractérisé en ce que** l'élément constitutif électronique (13) comporte au moins une partie saillante (20) en saillie à partir d'une paroi latérale (18) de l'élément constitutif électronique (13), qui coopère mécaniquement avec les éléments de butée du support (1).

5. Système d'assemblage selon l'une des revendications précédentes, **caractérisé en ce que** l'élément constitutif électronique (13) est bloqué avec le support (1) dans la position finale à l'aide de moyens de blocage.

6. Système d'assemblage selon la revendication 5, **caractérisé en ce que** les moyens de blocage comprennent une partie saillante (24) logée de façon élastique sur l'élément constitutif électronique (13), cette partie étant agencée, dans la position finale, dans un évidement (5) du support (1).

7. Système d'assemblage selon l'une des revendications précédentes, **caractérisé en ce que**, dans la position ouverte, au cours du mouvement pivotant et dans la position finale, une surface latérale (2) de l'élément constitutif électronique (13) et une surface latérale (22) du support (1) sont agencées au moins partiellement de manière juxtaposée.

8. Système d'assemblage selon l'une des revendications précédentes, **caractérisé en ce que** le support (1) est un support pouvant être assemblé à l'aide de la technique de SMD (technique de dispositifs montés en surface) qui comporte des surfaces de soudage (9) sur une surface inférieure (8) du fond (6).

9. Système d'assemblage selon l'une des revendications précédentes, **caractérisé en ce que** le support (1) comprend un élément constitutif de raccordement (11) avec des contacts de raccordement (12), qui exercent, dans la position finale, une force de ressort sur les surfaces de raccordement (15) de l'élément constitutif électronique (13).

10. Système d'assemblage selon l'une des revendications précédentes, **caractérisé en ce que** l'élément de butée (17) se trouve en contact, dans la position de butée, avec une partie saillante (20) de l'élément constitutif électronique (13), qui est en saillie à partir d'une paroi latérale (18, 19) de l'élément constitutif électronique (13) dans une direction perpendiculaire au mouvement relatif (A) de l'élément constitutif électronique (13).

11. Système d'assemblage selon les revendications 2 et 10, **caractérisé en ce qu'**une partie saillante (17) du support (1) sert respectivement d'élément de butée pour une partie saillante adjointe (20) de l'élément constitutif électronique (13).

12. Système d'assemblage selon l'une des revendications 2 à 11, **caractérisé en ce que** l'élément de butée conçu comme une partie saillante (17) est agencé au niveau de la face frontale (16) du support (1).

13. Système d'assemblage selon l'une des revendications précédentes, **caractérisé en ce que**, aussi bien le support (1) que l'élément constitutif électronique (13) comportent respectivement deux parois latérales s'étendant parallèlement (2, 3 ; 18, 19), respectivement une paroi latérale (2, 3) du support (1) et une paroi latérale (18, 19) de l'élément constitutif électronique (13) étant agencées dans la position ouverte, au cours du mouvement pivotant et dans la position finale, de manière au moins partiellement juxtaposée.
